# EUROPEAN PATENT APPLICATION

(11) **EP 3 780 099 A1**
(43) Date of publication of application: **17.02.2021**
(21) Application number: 19778231.1
(22) Date of filing: 08.02.2019
(51) Int. Cl.: H01L 25/07, H01L 23/48, H01L 25/18

(54) **SEMICONDUCTOR MODULE**

(30) Priority: 26.03.2018 JP 2018057382
(71) Applicant: Panasonic Intellectual Property Management Co., Ltd., Osaka-shi, Osaka 540-6207 (JP)
(72) Inventor: OKAURA, Shingo, Osaka-shi Osaka 540-6207 (JP); KIMURA, Junichi, Osaka-shi Osaka 540-6207 (JP); MATSUMOTO, Atsushi, Osaka-shi Osaka 540-6207 (JP)
(74) Representative: Vigand, Philippe
(86) International application number: PCT/JP2019/004715
(87) International publication number: WO 2019/187700

(57) **Abstract**

A semiconductor module according to the present disclosure includes: an insulating substrate; a first conductor disposed on the insulating substrate; a second conductor disposed on the insulating substrate; a first semiconductor element disposed on the first conductor; a second semiconductor element disposed on the second conductor; a first busbar connected to the first conductor in a region between the first semiconductor element and the second semiconductor element; a second busbar connected to the second semiconductor element; and an output busbar connecting the first semiconductor element to the second conductor and connected to the second conductor in the region between the first semiconductor element and the second semiconductor element. The output busbar is disposed at least partially overlapping the first busbar, and in an overlap region between the output busbar and the first busbar, the output busbar is located above the first busbar.

## Description

### TECHNICAL FIELD

The present disclosure relates to semiconductor modules used for various electronic devices.

### BACKGROUND ART

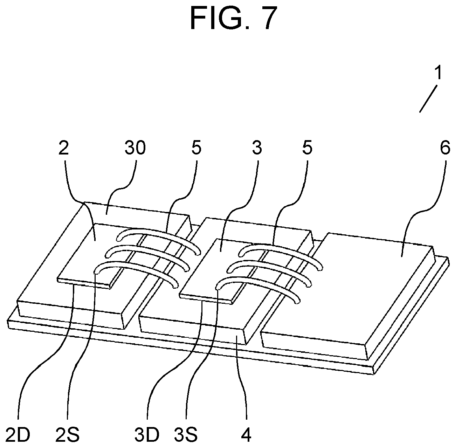

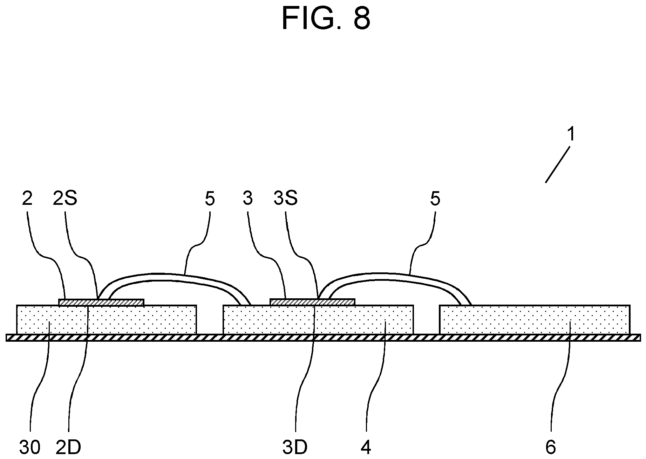

Hereinafter, a conventional semiconductor module will be described with reference to the drawings. FIG. 7 is a perspective view illustrating the configuration of conventional semiconductor module 1, and FIG. 8 is a cross-sectional view illustrating the configuration of conventional semiconductor module 1; semiconductor module 1 includes upper arm semiconductor 2 and lower arm semiconductor 3. Positive electrode terminal 30 to which a positive voltage is supplied is connected to drain electrode 2D of upper arm semiconductor 2, lead 5 is connected to source electrode 2S of upper arm semiconductor 2, and lead 5 is connected to output terminal 4. Output terminal 4 is connected to drain electrode 3D of lower arm semiconductor 3, lead 5 is connected to source electrode 3S of lower arm semiconductor 3, and lead 5 is connected to negative electrode terminal 6.

Since a large current flows between source electrode 2S and output terminal 4 and between source electrode 3S and negative electrode terminal 6, the plurality of leads 5 are connected in parallel to secure electrical capacity.

Note that Patent Literature (PTL) 1, for example, is known as related art document information pertaining to the present application.

### Citation List

### Patent Literature

PTL 1: International Publication No. WO2016/002385

### SUMMARY OF THE INVENTION

A semiconductor module according to one aspect of the present disclosure includes: an insulating substrate having a surface in a first direction; a first conductor disposed on the surface of the insulating substrate, the first conductor having a surface in the first direction; a second conductor disposed on the surface of the insulating substrate, the second conductor having a surface in the first direction; a first semiconductor element disposed on the surface of the first conductor; a second semiconductor element disposed on the surface of the second conductor, the second semiconductor element being located in a second direction viewed from the first semiconductor element; a first busbar connected to the surface of the first conductor in a region between the first semiconductor element and the second semiconductor element as viewed in the first direction, the first busbar being supplied with one of a first potential and a second potential; a second busbar connected to the second semiconductor element, the second busbar being supplied with an other of the first potential and the second potential; and an output busbar connected to the surface of the second conductor in the region between the first semiconductor element and the second semiconductor element as viewed in the first direction, the output busbar connecting the first semiconductor element to the surface of the second conductor. The output busbar is disposed partially overlapping the first busbar as viewed in the first direction. The output busbar is located in the first direction viewed from the first busbar in a region where the output busbar and the first busbar overlap each other, as viewed in the first direction. The output busbar outputs the first potential or the second potential supplied to the first semiconductor element or the second semiconductor element.

According to the present disclosure, the first busbar connected to the first conductor is disposed facing the output busbar in closer proximity than the first conductor is. Therefore, when electric power supplied from the outside through the first semiconductor element in particular is supplied to the output end, the magnetic flux generated at the output busbar and the magnetic flux generated at the first busbar are easily cancelled out, and thus the value of an inductance component at each of the output busbar and the first busbar is kept small. Furthermore, it becomes easy to obtain a capacitance component that is generated between the first busbar and the output busbar, and thus inductance components at both the first busbar and the output busbar which become a factor that causes a surge voltage along with an instantaneous increase in impedance are reduced. As a result, when the switching frequency of the semiconductor element increases, the occurrence of a surge voltage can be reduced as well.

### BRIEF DESCRIPTION OF THE DRAWINGS

FIG. 1 is a perspective view illustrating the configuration of a semiconductor module according to Embodiment 1 of the present disclosure.
FIG. 2 is a cross-sectional view illustrating the configuration of a semiconductor module according to Embodiment 1 of the present disclosure.
FIG. 3 is a schematic circuit block diagram illustrating the configuration of a semiconductor module according to Embodiment 1 of the present disclosure.
FIG. 4 is a cross-sectional view illustrating the configuration of a semiconductor module according to Embodiment 2 of the present disclosure.
FIG. 5 is a cross-sectional view illustrating the configuration of a semiconductor module according to Embodiment 3 of the present disclosure.
FIG. 6 is a perspective view illustrating the configuration of a semiconductor module according to Embodiment 4 of the present disclosure.
FIG. 7 is a perspective view illustrating the configuration of a conventional semiconductor module.
FIG. 8 is a cross-sectional view illustrating the configuration of a conventional semiconductor module.

### DESCRIPTION OF EMBODIMENTS

In conventional semiconductor module 1 described with reference to FIG. 7 and FIG. 8, a large current flows through lead 5, and there are many inductance components. Therefore, there is the problem that particularly, when the switching frequency of upper arm semiconductor 2 or lower arm semiconductor 3 increases, the occurrence of a surge voltage along with an instantaneous increase in impedance results in application of an excessive voltage to upper arm semiconductor 2 or lower arm semiconductor 3, which may lead to breakage, degradation, etc.

With the semiconductor module according to the present disclosure, it is possible to reduce the occurrence of a surge voltage.

### EMBODIMENT 1

### [Configuration of Semiconductor Module 7]

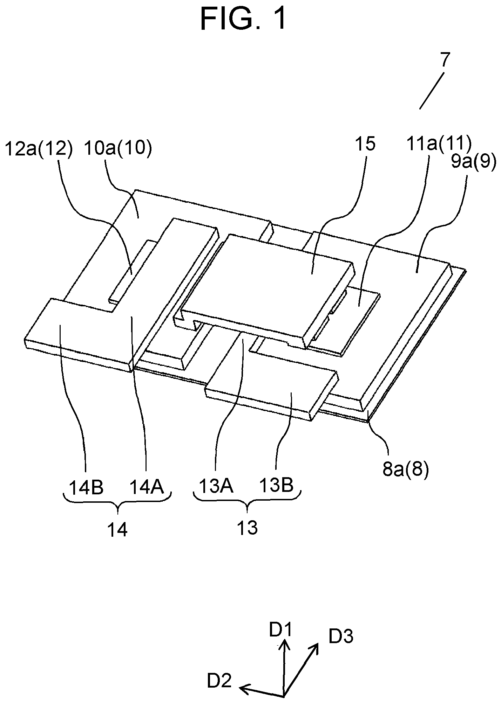

Hereinafter, the configuration of semiconductor module 7 according to Embodiment 1 of the present disclosure will be described with reference to FIG. 1 to FIG. 3.

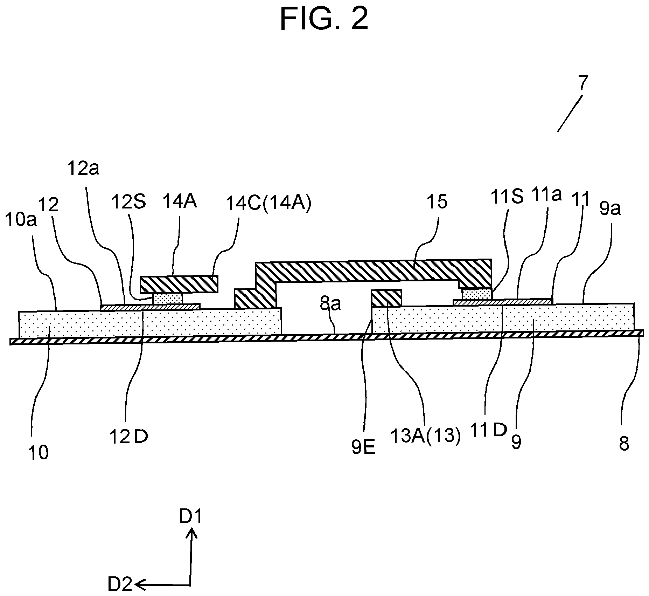

FIG. 1 is a perspective view illustrating the configuration of semiconductor module 7 according to Embodiment 1 of the present disclosure, and FIG. 2 is a cross-sectional view illustrating the configuration of semiconductor module 7 according to Embodiment 1 of the present disclosure. Semiconductor module 7 includes insulating substrate 8, first conductor 9, second conductor 10, first semiconductor element 11, second semiconductor element 12, first busbar 13, second busbar 14, and output busbar 15.

First conductor 9 and second conductor 10 are disposed on surface 8a of insulating substrate 8 that is located in first direction D1 (refer to FIG. 2). First semiconductor element 11 is disposed on surface 9a of first conductor 9 that is located in first direction D1. Second semiconductor element 12 is disposed on surface 10a of second conductor 10 that is located in first direction D1. Second semiconductor element 12 is located in second direction D2 from the first semiconductor element. One of a positive potential (first potential) and a negative potential (second potential) is supplied from the outside to first busbar 13 (not illustrated in the drawings). Although described later, it should be noted that the present exemplary embodiment describes an example in which the positive potential is supplied from the outside to first busbar 13. One end (connecting portion 13A) of first busbar 13 is disposed connected to surface 9a of first conductor 9 in a region between first semiconductor element 11 and second semiconductor element 12. Second busbar 14 is connected to source electrode 12S formed on surface 12a of second semiconductor element 12 that is located in first direction D1. The other of the positive potential and the negative potential, one of which is supplied to first busbar 13, is supplied to second busbar 14. Specifically, when the potential supplied to first busbar 13 is a positive potential, the potential supplied to second busbar 14 is a negative potential; when the potential supplied to first busbar 13 is a negative potential, the potential supplied to second busbar 14 is a positive potential.

Output busbar 15 connects, to surface 10a of second conductor 10 (the upper surface of second conductor 10 in FIG. 2), source electrode 11S formed on surface 11a of first semiconductor element 11 (the upper surface of first semiconductor element 11 in FIG. 2). Second conductor 10 is electrically connected to drain electrode 12D of second semiconductor element 12, resulting in output busbar 15 electrically connecting drain electrode 12D of second semiconductor element 12 to source electrode 11 of first semiconductor element 11.

Furthermore, output busbar 15 covers a surface of first busbar 13 that is located in the first direction (the upper surface of first busbar 13). In other words, as viewed in first direction D1, output busbar 15 is disposed overlapping at least a portion (connecting portion 13A) of first busbar 13 on the first conductor. Output busbar 15 is located in first direction D1 from first busbar 13 in an overlap region between output busbar 15 and first busbar 13, as viewed in first direction D1.

Output busbar 15 outputs the positive potential or the negative potential supplied from the outside to first semiconductor element 11 or second semiconductor element 12.

With the above configuration, first busbar 13 (connecting portion 13A) connected to first conductor 9 is disposed facing output busbar 15 in closer proximity than first conductor 9 is. Therefore, when the electric power (the positive potential or the negative potential) supplied from the outside through first semiconductor element 11 is output through output busbar 15, the magnetic flux generated at output busbar 15 and the magnetic flux generated at first busbar 13 are easily cancelled out. Thus, the value of an inductance component at each of output busbar 15 and first busbar 13 is kept small. Furthermore, it becomes easy to obtain a capacitance component that is generated between first busbar 13 and output busbar 15. This capacitance component reduces the effects of inductance components at both first busbar 13 and output busbar 15 which become a factor that causes a surge voltage. As a result, when the switching frequency of first semiconductor element 11 or second semiconductor element 12 increases, an instantaneous increase in impedance is reduced, and the occurrence of a surge voltage can be reduced as well. Thus, breakage, degradation, etc., of first semiconductor element 11 and second semiconductor element 12 due to application of a high voltage are reduced.

### [Detailed Configuration of Semiconductor Module 7]

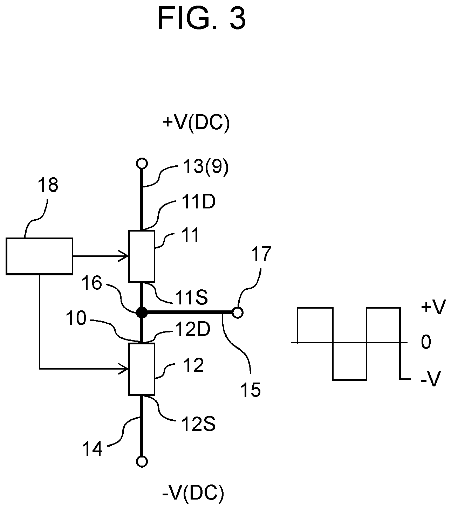

Hereinafter, the configuration of semiconductor module 7 will be described in detail with reference to FIG. 1, FIG. 2, and FIG. 3. FIG. 3 is a schematic circuit block diagram illustrating the configuration of semiconductor module 7 according to the present disclosure.

First, the connection and operation of semiconductor module 7 will be described in a simplified manner. FIG. 3 is a schematic circuit block diagram of semiconductor module 7, illustrating, as an example, a case where drain electrode 11D of first semiconductor element 11 is connected to the positive potential and source electrode 12S of second semiconductor element 12 is connected to the negative potential. In FIG. 3, although the diagram is schematic, the portion representing first semiconductor element 11 is a circuit block including first semiconductor element 11, and the portion representing second semiconductor element 12 is a circuit block including second semiconductor element 12.

As illustrated in FIG. 3, a positive potential (+V) and a negative potential (-V) are supplied from the outside to semiconductor module 7. In the present example, the positive potential is supplied to first busbar 13; the positive potential may be directly supplied to first busbar 13 or may be supplied to a positive potential terminal (not illustrated in the drawings) provided connected to first busbar 13 as a separate element. The negative potential is supplied to second busbar 14; the negative potential may be directly supplied to second busbar 14 or may be supplied to a negative potential terminal (not illustrated in the drawings) provided connected to second busbar 14 as a separate element.

Drain electrode 11D of first semiconductor element 11 included in the upper arm is connected to first busbar 13 via first conductor 9. Source electrode 11S of first semiconductor element 11 included in the upper arm is electrically connected to drain electrode 12D of second semiconductor element 12 included in the lower arm. In FIG. 3, the portion connecting source electrode 11S of first semiconductor element 11 and drain electrode 12D of second semiconductor element 12 is indicated as connecting portion 16. Source electrode 12S of second semiconductor element 12 is connected to second busbar 14.

Second conductor 10 and output busbar 15 illustrated in FIG. 2 correspond to second conductor 10, connecting portion 16, output busbar 15, and output portion 17 illustrated in FIG. 3. Although output portion 17 and output busbar 15 are illustrated as separate elements in FIG. 3, output busbar 15 and output portion 17 may be integrated.

Furthermore, since second conductor 10, connecting portion 16, output busbar 15, and output portion 17 have the same potential, output portion 17 may be directly connected to second conductor 10. Alternatively, output portion 17 may be integrated with second conductor 10.

As illustrated in FIG. 3, controller 18 which controls driving of first semiconductor element 11 and driving of second semiconductor element 12 is connected to first semiconductor element 11 and second semiconductor element 12. Note that controller 18 may be provided in semiconductor module 7 or may be provided outside semiconductor module 7. Controller 18 controls first semiconductor element 11 and second semiconductor element 12 so that first semiconductor element 11 and second semiconductor element 12 alternately turn ON (connection) and OFF (disconnection). As a result of the control of first semiconductor element 11 and second semiconductor element 12 by controller 18, the positive potential (+V) and the negative potential (-V) are alternately output to output portion 17. In this manner, semiconductor module 7 converts direct-current power at the positive potential and the negative potential into alternating-current power and outputs the alternating-current power from output portion 17.

### [Variation of Structure of Semiconductor Module 7]

Next, another example of the structure of semiconductor module 7 will be described with reference to FIG. 2. In semiconductor module 7 illustrated in FIG. 2, first conductor 9 and second conductor 10 are disposed on surface 8a (the surface located in first direction D1) of insulating substrate 8. First conductor 9 and second conductor 10 are arranged spaced apart from each other in second direction D2. In FIG. 2, first conductor 9 and second conductor 10 are provided on the upper surface (surface 8a) of insulating substrate 8. However, first conductor 9 and second conductor 10 may be embedded in insulating substrate 8 by setting the thickness of insulating substrate 8 in first direction D1 greater than the thickness of each of first conductor 9 and second conductor 10 in first direction D1. In this configuration, the upper surfaces of first conductor 9 and second conductor 10 are at least partially exposed from insulating substrate 8.

Note that first conductor 9 and second conductor 10 may each be a layer-shaped conductor having a small thickness in first direction D1. With this configuration, the heat transfer to insulating substrate 8 improves.

Furthermore, first conductor 9 and second conductor 10 may each be in the form of a board, a lead frame, or a block having a large thickness in first direction D1. With this configuration, the electrical conductivity, the heat dissipation, etc., improve.

As illustrated in FIG. 2, in semiconductor module 7 according to the present disclosure, first semiconductor element 11 is disposed on surface 9a of first conductor 9. Although not illustrated in FIG. 2, welding such as soldering is used for the mounting/joining. Furthermore, drain electrode 11D is provided on a mounting surface of first semiconductor element 11 for first conductor 9.

Furthermore, as illustrated in FIG. 2, second semiconductor element 12 is disposed on surface 10a of second conductor 10. Although not illustrated in FIG. 2, welding such as soldering is used for the mounting/joining. Furthermore, drain electrode 12D is provided on a mounting surface of second semiconductor element 12 for second conductor 10.

### [Detailed Configuration of First Busbar 13]

The positive potential is supplied from the outside of semiconductor module 7 to first busbar 13 (refer to FIG. 3). As illustrated in FIG. 2, first busbar 13 is disposed connected to surface 9a of first conductor 9 in a region between first semiconductor element 11 and second semiconductor element 12. First busbar 13 and first semiconductor element 11 are provided in first direction D1 from first conductor 9, and second semiconductor element 12 is provided in first direction D1 from second conductor 10. First busbar 13 includes connecting portion 13A and lead-out portion 13B, and connecting portion 13A and lead-out portion 13B are formed of an integrated single conductor. At least connecting portion 13A is disposed on surface 9a of first conductor 9. On the other hand, lead-out portion 13B does not necessarily need to be disposed on surface 9a of first conductor 9a as long as lead-out portion 13B is disposed at a position suitable for supplying the positive potential; lead-out portion 13B may be lead out in a form equivalent to a terminal. Furthermore, first busbar 13 and first conductor 9 may be provided as a single conductor. Moreover, first busbar 13 may be provided on surface 9a of first conductor 9 by welding such as soldering.

### [Detailed Configuration of Second Busbar 14]

Second busbar 14 is connected to second semiconductor element 12. Source electrode 12S is provided on surface 12a of second semiconductor element 12, and second busbar 14 is electrically connected to source electrode 12S. Second busbar 14 and source electrode 12S are joined together by welding such as soldering. The negative potential is supplied from the outside of semiconductor module 7 to second busbar 14. Furthermore, connecting portion 14A of second busbar 14 faces at least output busbar 15 in second direction D2 and includes protrusion 14C extending in the direction opposite to second direction D2 relative to second semiconductor element 12 as viewed in first direction D1 (refer to FIG. 2). In other words, as viewed in first direction D1, an end of connecting portion 14A of second busbar 14 that is located in the direction opposite to second direction D2 is closer to output busbar 15 than an end of second semiconductor element 12 that is located in the direction opposite to second direction D2 is.

With this configuration, it is possible to increase the value of a capacitance component that is generated between second busbar 14 and output busbar 15.

Furthermore, in order to adjust the value of a capacitance component that is generated between second busbar 14 and output busbar 15, the positional relationship may be such that as viewed inf first direction D1, the end of connecting portion 14A of second busbar 14 that is located in the direction opposite to second direction D2 matches the end of second semiconductor element 12 that is located in the direction opposite to second direction D2. Furthermore, as viewed in first direction D1, the end of connecting portion 14A of second busbar 14 that is located in the direction opposite to second direction D2 may be positioned farther away from output busbar 15 than the end of second semiconductor element 12 that is located in the direction opposite to second direction D2 is.

Similar to first busbar 13, second busbar 14 includes connecting portion 14A and lead-out portion 14B, and connecting portion 14A includes protrusion 14C. Connecting portion 14A and lead-out portion 14B are formed of an integrated single conductor. Lead-out portion 14B is disposed at a position suitable for supplying the positive potential and may be lead out in a form equivalent to a terminal.

### [Detailed Configuration of Output Busbar 15]

Output busbar 15 connects first semiconductor element 11 and surface 10a of second conductor 10. The position at which output busbar 15 is connected to second conductor 10 is located between second semiconductor element 12 and first semiconductor element 11. In other words, one end of output busbar 15 is connected to surface 10a of second conductor 10. First semiconductor element 11 has source electrode 11S, and source electrode 11S is provided on surface 11a of first semiconductor element 11. Output busbar 15 is connected to source electrode 11S. Output busbar 15 and source electrode 11S are joined together by welding such as soldering. Likewise, output busbar 15 and second conductor 10 are joined together by welding such as soldering.

Furthermore, output busbar 15 covers connecting portion 13A of first busbar 13. Note that output busbar 15 and first busbar 13 are not in contact with each other. As mentioned earlier, connecting portion 13A of first busbar 13 is located between first semiconductor element 11 and second semiconductor element 12. Therefore, output busbar 15 connecting first semiconductor element 11 and surface 10a of second conductor 10 extends across connecting portion 13A, which is a part of first busbar 13.

As is clear from the foregoing description, connecting portion 13A of first busbar 13 connected to first conductor 9 is located on surface 9a of first conductor 9. Connecting portion 13A of first busbar 13 is disposed in closer proximity to output busbar 15 than first conductor 9 is in first direction D1. With this configuration, when electric power supplied from the outside through first semiconductor element 11 is supplied to the output end via output busbar 15, the magnetic flux generated at output busbar 15 and the magnetic flux generated at first busbar 13 are easily cancelled out, and thus the value of an inductance component at each of output busbar 15 and first busbar 13 is kept small. Furthermore, it becomes easy to obtain a capacitance component that is generated between first busbar 13 and output busbar 15, and this capacitance component reduces the effects of inductance components at both first busbar 13 and output busbar 15 which become a factor that causes a surge voltage. As a result, when the switching frequency of first semiconductor element 11 or second semiconductor element 12 increases, the occurrence of a surge voltage can be reduced as well.

Furthermore, since there is output busbar 15 between first busbar 13 and second busbar 14 as illustrated in FIG. 2, it is possible to generate capacitance both between first busbar 13 and output busbar 15 and between second busbar 14 and output busbar 15. Therefore, these capacitance components reduce the effects of inductance components both at first busbar 13 and output busbar 15 and at second busbar 14 and output busbar 15 which become a factor that causes a surge voltage. As a result, when the switching frequency of first semiconductor element 11 or second semiconductor element 12 increases, the occurrence of a surge voltage can be reduced.

The capacitance can be increased even when the thickness of first busbar 13 in first direction D1 is less than or equal to the thickness of first semiconductor element 11 in first direction D1. Therefore, dead space of surface 9a of first conductor 9 can be used and thus, it is possible to reduce the thickness dimension of semiconductor module 7 in first direction D1.

### EMBODIMENT 2

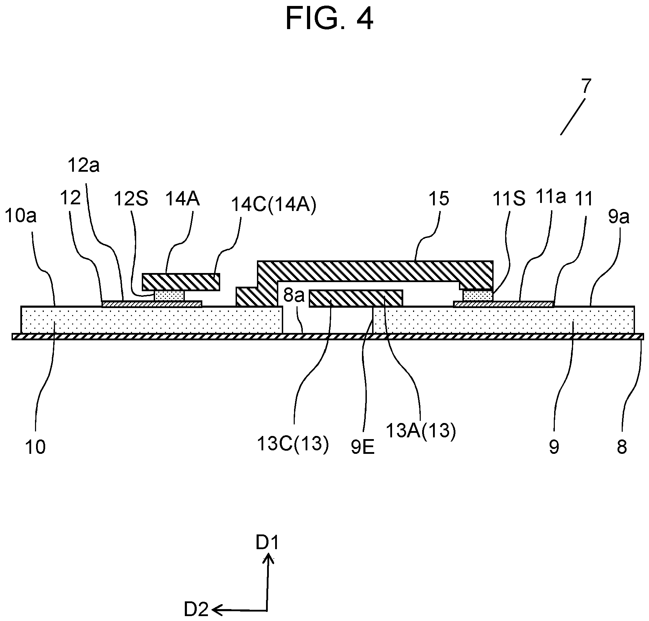

Next, the configuration of semiconductor module 7 according to Embodiment 2 of the present disclosure will be described with reference to FIG. 4. Note that elements that are substantially the same as those in Embodiment 1 described with reference to FIG. 3 are assigned the same reference marks and description thereof may be omitted.

FIG. 4 is a cross-sectional view illustrating the configuration of semiconductor module 7 according to Embodiment 2 of the present disclosure. As illustrated in FIG. 4, first busbar 13 extends from end 9E of first conductor 9 toward second semiconductor element 12 (in second direction D2). Note that a section of first busbar 13 that extends from end 9E of first conductor 9 toward second semiconductor element 12 is denoted as "busbar extension 13C" in particular. Here, end 9E of first conductor 9 corresponds to a section of first conductor 9 that faces second conductor 10.

As mentioned earlier, connecting portion 13A of first busbar 13 is provided on surface 9a of first conductor 9. In other words, connecting portion 13A of first busbar 13 is provided in a region between first semiconductor element 11 and second semiconductor element 12. Thus, connecting portion 13A significantly contributes to the magnetic flux cancellation and the increase in capacitance components.

Therefore, with busbar extension 13C, the area of facing sections of first busbar 13 and output busbar 15 further increases, and thus the magnetic flux generated at output busbar 15 and the magnetic flux generated at first busbar 13 are efficiently cancelled out, leading to a significant reduction in the value of an inductance component at each of output busbar 15 and first busbar 13. Furthermore, it becomes easy to obtain a capacitance component that is generated between first busbar 13 and output busbar 15, and this capacitance component reduces the effects of inductance components at both first busbar 13 and output busbar 15 which become a factor that causes a surge voltage. As a result, when the switching frequency of first semiconductor element 11 or second semiconductor element 12 increases, the occurrence of a surge voltage can be reduced as well.

### EMBODIMENT 3

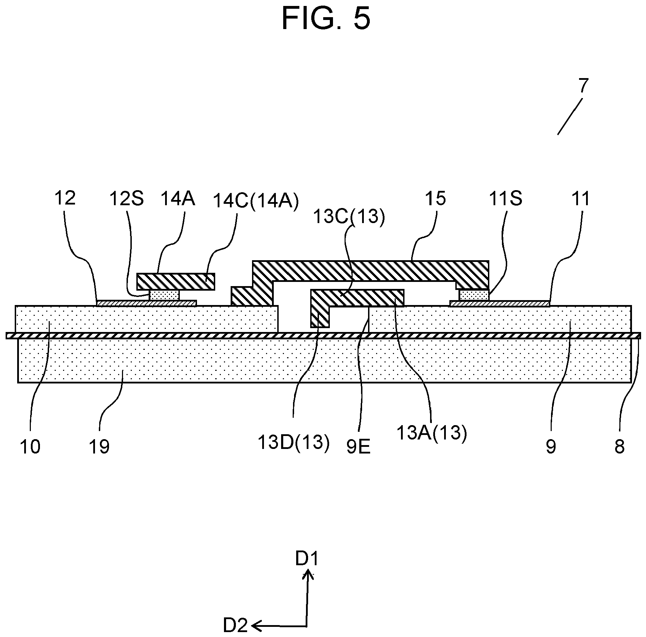

Next, the configuration of semiconductor module 7 according to Embodiment 3 of the present disclosure will be described with reference to FIG. 5. Note that elements that are substantially the same as those in Embodiment 2 described with reference to FIG. 4 are assigned the same reference marks and description thereof may be omitted.

In semiconductor module 7 according to the present exemplary embodiment illustrated in FIG. 5, first busbar 13 further includes busbar hook-shaped portion 13D. Busbar hook-shaped portion 13D extends toward insulating substrate 8 (opposite to first direction D1) from a tip of busbar extension 13C in the protruding direction (second direction D2) which extends from end 9E of first conductor 9 toward second semiconductor element 12. Note that busbar hook-shaped portion 13D may extend not from the tip of busbar extension 13C but from the vicinity of the tip in the direction opposite to first direction D1.

With busbar hook-shaped portion 13D, it becomes easy to obtain a capacitance component that is generated between first busbar 13 and output busbar 15, reducing the effects of inductance components at both first busbar 13 and output busbar 15 which become a factor that causes a surge voltage. As a result, when the switching frequency of first semiconductor element 11 or second semiconductor element 12 increases, the occurrence of a surge voltage can be reduced as well.

Note that as illustrated in FIG. 5, heat dissipator 19 may be disposed on a surface of insulating substrate 8 (the lower surface of the insulating substrate in the figure) opposite to the surface thereof on which first conductor 9 and the second conductor are disposed. With this, the heat dissipation properties of semiconductor module 7 improve. This configuration is not limited to the present exemplary embodiment; heat dissipator 19 may be disposed in another exemplary embodiment.

### EMBODIMENT 4

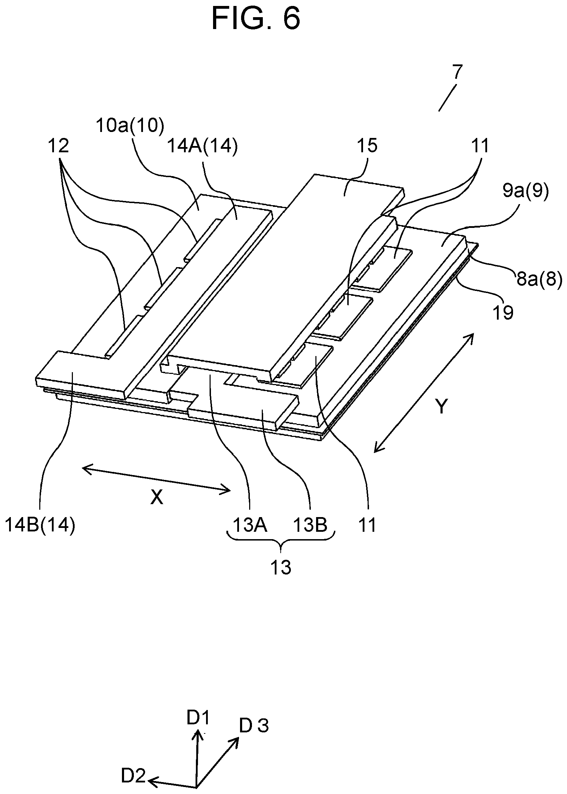

Next, the configuration of semiconductor module 7 according to Embodiment 4 of the present disclosure will be described with reference to FIG. 6. Note that elements that are substantially the same as those in Embodiment 1 described with reference to FIG. 1 are assigned the same reference marks and description thereof may be omitted.

As illustrated in FIG. 6, in the present exemplary embodiment, the direction which is parallel to surface 8a of insulating substrate 8 and in which first conductor 9 and second conductor 10 face each other is represented by the X-direction (or second direction D2), and the direction which is parallel to surface 8a of insulating substrate 8 and in which connecting portion 14A of second busbar 14 extends is represented by the Y-direction (or third direction D3), for the sake of explanation. Note that the X-direction and the Y-direction are orthogonal to each other.

As illustrated in FIG. 6, each of first conductor 9, second conductor 10, first busbar 13, second busbar 14, and output busbar 15 includes a rectangular portion which is parallel to surface 8a of insulating substrate 8 and extends in the Y-direction.

In other words, each of first conductor 9, second conductor 10, connecting portion 13A of first busbar 13, connecting portion 14A of second busbar 14, and output busbar 15 corresponds to a rectangular portion in a top view. Furthermore, each of first conductor 9, second conductor 10, connecting portion 13A of first busbar 13, connecting portion 14A of second busbar 14, and output busbar 15 is longer in the Y-direction (third direction D3) than in the X-direction (second direction D2) in the top view.

In this configuration, the ratio of the length in the Y-direction in which the capacitance component is likely to increase with the length by first busbar 13, second busbar 14, and output busbar 15 to the length in the X-direction which is the direction of flow of an electric current flowing inside semiconductor module 7 and in which the inductance component is likely to increase with the length is greater than that in Embodiment 1 illustrated in FIG. 1. With reference to FIG. 3, the route in the X-direction corresponds to the route from first busbar 13 to output portion 17 in which the positive potential (+V) is supplied and the route from second busbar 14 to output portion 17 in which the negative potential (-V) is supplied. For example, an increase only in the length in the Y-direction with the length in the X-direction unchanged results in an increase in the capacitance component. Accordingly, the capacitance component generated inside semiconductor module 7 reduces the effects of the inductance components generated likewise inside semiconductor module 7. As a result, when the switching frequency of first semiconductor element 11 or second semiconductor element 12 increases, the occurrence of a surge voltage can be reduced as well.

As illustrated in FIG. 6, a plurality of first semiconductor elements 11 are disposed on surface 9a of first conductor 9 side by side in the Y-direction (third direction D3). Similarly, a plurality of second semiconductor elements 12 are disposed on surface 10a of second conductor 10 side by side in the Y-direction (third direction D3). As mentioned earlier, each of first conductor 9, second conductor 10, connecting portion 13A of first busbar 13, connecting portion 14A of second busbar 14, and output busbar 15 is in the shape of a rectangle elongated in the Y-direction in the top view in FIG. 6. Therefore, the plurality of first semiconductor elements 11 can be arranged in columns on surface 9a of first conductor 9, and the plurality of second semiconductor elements 12 can be arranged in columns on surface 10a of second conductor 10.

The plurality of first semiconductor elements 11 are connected in parallel and are controlled by controller 18 so as to be turned ON (connection) and OFF (disconnection) in synchronization. Similarly, the plurality of second semiconductor elements 12 are connected in parallel and are controlled by controller 18 so as to be turned ON (connection) and OFF (disconnection) in synchronization. With this configuration, semiconductor module 7 can easily output a large electric power. Furthermore, the operational load on each of the plurality of first semiconductor elements 11 and each of the plurality of second semiconductor elements 12 is lightened. Moreover, the heat sources of the plurality of first semiconductor elements 11 and the plurality of second semiconductor elements 12 are distributed in multiple positions. As a result, the increase in the temperature of semiconductor module 7 during operation can be reduced.

Although terms indicating directions in the drawings such as "upper" and "lower" are used in the foregoing description of the exemplary embodiments, these merely indicate relative positioning in the drawings and are not meant to limit the present disclosure.

As mentioned earlier, in the above-described exemplary embodiments, first busbar 13 and first semiconductor element 11 are connected to the positive potential, and second busbar 14 and second semiconductor element 12 are connected to the negative potential, as an example, but first busbar 13 and first semiconductor element 11 may be connected to the negative potential, and second busbar 14 and second semiconductor element 12 may be connected to the positive potential. In the case where first busbar 13 and first semiconductor element 11 are connected to the negative potential, and second busbar 14 and second semiconductor element 12 are connected to the positive potential, it is sufficient that the connections between source electrode 11S of first semiconductor element 11, source electrode 12S of second semiconductor element 12, drain electrode 11D of first semiconductor element 11, and drain electrode 12D of second semiconductor element 12 in the above-described exemplary embodiments be reversed.

Note that in the above exemplary embodiments, the first potential is described as the positive potential and the second potential is described as the negative potential, but these potentials do not necessarily need to be the positive and negative potentials. It is sufficient that these potentials be two different potentials.

### (Closing)

Semiconductor module 7 according to one aspect of the present disclosure includes: insulating substrate 8 having surface 8a in first direction 8a; first conductor 9 disposed on surface 8a of insulating substrate 8 and having surface 9a in first direction D1; second conductor 10 disposed on surface 8a of insulating substrate 8 and having surface 10a in first direction D1; first semiconductor element 11 disposed on surface 9a of first conductor 9; second semiconductor element 12 disposed on surface 10a of second conductor 10 and located in second direction D2 viewed from first semiconductor element 11; first busbar 13 connected to surface 9a of first conductor 9 in a region between first semiconductor element 11 and second semiconductor element 12 as viewed in first direction D1, and supplied with one of a first potential (positive potential) and a second potential (negative potential); second busbar 14 connected to second semiconductor element 12 and supplied with the other of the positive potential and the negative potential; and output busbar 15 connecting first semiconductor element 11 to surface 10a of second conductor 10 and connected to surface 10a of second conductor 10 in the region between first semiconductor element 11 and second semiconductor element 12 as viewed in first direction D1. Output busbar 15 is disposed at least partially overlapping first busbar 13 as viewed in first direction D1. Output busbar 15 is located in first direction D1 viewed from first busbar 13 in a region where output busbar 15 and first busbar 13 overlap each other, as viewed in first direction D1. Output busbar 15 outputs the first potential (positive potential) or the second potential (negative potential) supplied to first semiconductor element 11 or second semiconductor element 12.

In semiconductor module 7 according to one aspect of the present disclosure, first busbar 13 may further include busbar extension 13C extending in second direction D2 relative to end 9E of first conductor 9 in second direction D2 as viewed in first direction D1, and busbar extension 13C may face output busbar 15.

In semiconductor module 7 according to one aspect of the present disclosure, first busbar 13 may further include busbar hook-shaped portion 13D extending from busbar extension 13C in a direction opposite to first direction D1.

In semiconductor module 7 according to one aspect of the present disclosure, each of first conductor 9, second conductor 10, first busbar 13, second busbar 14, and output busbar 15 may include a rectangular portion longer in third direction D3 perpendicular to first direction D1 and second direction D2 than in second direction D2 as viewed in first direction D1.

In semiconductor module 7 according to one aspect of the present disclosure, the plurality of first semiconductor elements 11 may be disposed on surface 9a of first conductor 9 side by side in third direction D3, and the plurality of second semiconductor elements 12 may be disposed on surface 10a of second conductor 10 side by side in third direction D3.

### INDUSTRIAL APPLICABILITY

The semiconductor module according to the present disclosure has the advantageous effect of reducing the occurrence of a surge voltage and is useful in various electronic devices.

### REFERENCE MARKS IN THE DRAWINGS

- 1: semiconductor module
- 2: upper arm semiconductor
- 2D: drain electrode
- 2S: source electrode
- 3: lower arm semiconductor
- 3D: drain electrode
- 3S: source electrode
- 4: output terminal
- 5: lead
- 6: negative electrode terminal
- 7: semiconductor module
- 8: insulating substrate
- 8a: surface
- 9: first conductor
- 9a: surface
- 9E: end
- 10: second conductor
- 10a: surface
- 11: first semiconductor element
- 11a: surface
- 11D: drain electrode
- 11S: source electrode
- 12: second semiconductor element
- 12a: surface
- 12D: drain electrode
- 12S: source electrode
- 13: first busbar
- 13A: connecting portion
- 13B: lead-out portion
- 13C: busbar extension
- 13D: busbar hook-shaped portion
- 14: second busbar
- 14A: connecting portion
- 14B: lead-out portion
- 14C: protrusion
- 15: output busbar
- 16: connecting portion
- 17: output portion
- 18: controller
- 19: heat dissipator
- 30: positive electrode terminal
- D1: first direction
- D2: second direction
- D3: third direction

## Claims

1. A semiconductor module, comprising:
an insulating substrate having a surface in a first direction;
a first conductor disposed on the surface of the insulating substrate, the first conductor having a surface in the first direction;
a second conductor disposed on the surface of the insulating substrate, the second conductor having a surface in the first direction;
a first semiconductor element disposed on the surface of the first conductor;
a second semiconductor element disposed on the surface of the second conductor, the second semiconductor element being located in a second direction viewed from the first semiconductor element;
a first busbar connected to the surface of the first conductor in a region between the first semiconductor element and the second semiconductor element as viewed in the first direction, the first busbar being supplied with one of a first potential and a second potential;
a second busbar connected to the second semiconductor element, the second busbar being supplied with an other of the first potential and the second potential; and
an output busbar connected to the surface of the second conductor in the region between the first semiconductor element and the second semiconductor element as viewed in the first direction, the output busbar connecting the first semiconductor element to the surface of the second conductor, wherein
the output busbar is disposed at least partially overlapping the first busbar as viewed in the first direction,
the output busbar is located in the first direction viewed from the first busbar in a region where the output busbar and the first busbar overlap each other, as viewed in the first direction, and
the output busbar outputs the first potential or the second potential supplied to the first semiconductor element or the second semiconductor element.

2. The semiconductor module according to claim 1, wherein
the first busbar further includes a busbar extension extending in the second direction relative to an end of the first conductor in the second direction as viewed in the first direction, and
the busbar extension faces the output busbar.

3. The semiconductor module according to claim 2, wherein
the first busbar further includes a busbar hook-shaped portion extending from the busbar extension in a direction opposite to the first direction.

4. The semiconductor module according to claim 1, wherein
each of the first conductor, the second conductor, the first busbar, the second busbar, and the output busbar includes a rectangular portion longer in a third direction than in the second direction as viewed in the first direction, the third direction being perpendicular to the first direction and the second direction.

5. The semiconductor module according to claim 4, wherein
the first semiconductor element is one of a plurality of first semiconductor elements,
the second semiconductor element is one of a plurality of second semiconductor elements,
the plurality of first semiconductor elements are disposed on the surface of the first conductor side by side in the third direction, and
the plurality of second semiconductor elements are disposed on the surface of the second conductor side by side in the third direction.
